(19) Europäisches Patentamt
European Patent Office
Office européen des brevets

(11) **EP 2 091 102 B1**

(12) **EUROPÄISCHE PATENTSCHRIFT**

(45) Veröffentlichungstag und Bekanntmachung des Hinweises auf die Patenterteilung:
**24.02.2010 Patentblatt 2010/08**

(51) Int Cl.:
*H01Q 1/34* (2006.01)      *H01Q 1/52* (2006.01)
*G01R 29/08* (2006.01)

(21) Anmeldenummer: **09001226.1**

(22) Anmeldetag: **29.01.2009**

(54) **Vorrichtung zur Durchführung eines EMV-Systemtestes**

Device for performing an EMV system test

Dispositif d'exécution d'un test de système EMV

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **18.02.2008 DE 102008010576**

(43) Veröffentlichungstag der Anmeldung:
**19.08.2009 Patentblatt 2009/34**

(73) Patentinhaber: **TKMS Blohm + Voss Nordseewerke GmbH 26725 Emden (DE)**

(72) Erfinder: **Harms, Dr. Harm-Friedrich 26632 Ihlow (DE)**

(74) Vertreter: **Hansmann, Dierk et al Patentanwälte Hansmann-Klickow-Hansmann Jessenstrasse 4 22767 Hamburg (DE)**

(56) Entgegenhaltungen:
**EP-A- 1 612 887        WO-A-00/34795
WO-A-2007/062839        DE-U1- 20 212 299**

**Beschreibung**

Die Erfindung bezieht sich auf eine Vorrichtung zur Durchführung eines EMV-Systemtestes für Antennen von VLF-Systemen im Turm von U-Booten im Überwasserbetrieb durch Schirmung elektromagnetischer Felder.

Eine Vorrichtung zur Schirmungelektromagnetischer Felder von Antennen über einen Faradaykäfig ist aus der Druckschrift EP 1 612 887 bekannt.

Während einem U-Boot über Wasser eine Vielzahl von externen Kommunikationssystemen zur Verfügung stehen, verbleibt unter Wasser lediglich der VLF-Frequenzbereich zum Empfang von Daten. Das VLF-Empfangssystem muß daher eine hohe Empfindlichkeit aufweisen. Doch im Bereich von 10 kHz bis 30 kHz gibt es häufig eine Vielzahl von Störquellen an Bord eines U-Bootes. Diese Störungen entstehen insbesondere durch statische Umrichter für die verschiedenen benötigten Versorgungsspannungen, Frequenzumrichter für Motoren und ähnliche Systeme. Für das Auffinden und Beseitigen möglicher Störquellen muß sich das Boot in einem Zustand befinden, in welchem eine maximale Schirmung von äußeren Signalen bzw. Störquellen vorhanden ist. Aufgrund der Dämpfung von Seewasser von ca. 2 dB/m bis 3 dB/m im fraglichen Frequenzbereich kann eine ausreichende Abschirmung externer Stör- und Nutzsignale durch Abtauchen des U-Bootes erzielt werden. Sowohl der EMV-Systemtest als auch eine mögliche Fehlersuche müssen daher im getauchten Zustand durchgeführt werden.

Im Verlauf eines EMV-Systemtestes werden nach Möglichkeit sämtliche Geräte ausgeschaltet und aus diesem elektrischen Grundzustand des U-Bootes wieder eingeschaltet (Zuschaltprüfung). Sind während dieser Prüfung Störungen im VLF-Empfang zu beobachten, so muß eine genaue Identifizierung der Störquelle und anschließende Beseitigung der Störung erfolgen.

Dieses Meßvorgehen birgt somit entsprechende Nachteile. So ist für jede Messung eine gewisse Tauch-Mindesttiefe erforderlich, um eine ausreichende Dämpfung zu erhalten. Andererseits müssen auch gewisse fahrtechnische Geräte durch die Zuschaltprüfung auf Störungen getestet werden, so daß erhebliche Sicherheitsabstände sowohl zum Meeresboden als auch zur Wasseroberfläche benötigt werden. Hieraus ergeben sich Voraussetzungen, welche Ausfahrten in sehr tiefe Gewässer erfordern. Dieses wiederum hat einen enormen zeitlichen Aufwand und damit verbundene Kosten für diese Erprobungen zur Folge.

Die Aufgabe der Erfindung ist es, auf einfache Weise einen EMV-Systemtest direkt im Oberwasserbereich durchzuführen und eine ausreichende Schirmung von außerhalb des Bootes kommende Störungen bis zur Empfängerempfindlichkeit zu reduzieren, um eine Fehlersuche und -beseitigung zu gewährleisten.

Die Lösung dieser Aufgabe erfolgt erfindungsgemäß dadurch, daß auf den Turm des U-Bootes eine haubenartige Umhüllung mit einem dem U-Boot zugewandten Aufnahmebereich für den Turm aufsetzbar ist und die Umhüllung mit Massebändern zum Eintauchen ins Umgebungswasser versehen ist, wobei die haubenartige Umhüllung aus einem elektrisch leitfähigen Material mit einer Leitfähigkeit und relativen Permeabilität zur elektromagnetischen Dämpfung der Störsignale der Umgebung im Bereich von 20 dB bis 40 dB ausgelegt ist.

Hierdurch werden die Vorteile erzielt, daß ein wesentlich geringerer organisatorischer Aufwand für den EMV-Systemtest und insbesondere für die Fehlersuche und -beseitigung auftritt. Gerade im Bereich sicherheitsrelevanter Systeme wie Navigation oder Antrieb ist eine vollständige Abschaltung bei einem getauchten U-Boot nicht immer möglich. Befindet sich das U-Boot jedoch Überwasser gesichert an einer Pier, so sind auch diese Systeme abschaltbar. Der ideale Ausgangspunkt für eine Zuschaltprüfung, das sogenannte tote Boot, ist tatsächlich erreichbar. Zudem können für eine Fehlersuche Modifikationen im System vorgenommen werden, wie z. B. eine Ver- bzw. Umlegung von Kabeln, ohne daß zusätzliche zeit- und kostenintensive Seetage geplant werden müssen.

Mittels der Vorrichtung wird eine Dämpfung erreicht, die vergleichbaren Tauchtiefen entspricht.

Es handelt sich um eine elektromagnetische Dämpfung. Diese resultiert aus der Summe der Reflexionsdämpfung, der Absorptionsdämpfung, der Dämpfung aus Mehrfachreflexionen verringert um die Dämpfung durch Leckagen (Öffnungen). Die Dämpfung muß ausreichen, um die elektromagnetischen Störsignale der Umgebung im relevanten Frequenzbereich unter die Schwelle zu bringen, die sich aus der Empfindlichkeit der Empfangssignale ergibt. Die Empfangsanlage wird dabei durch die Kombination von Antenne, Antennenkabel und Empfänger gebildet. Diese Differenz aus dem Pegel der Störsignale und der Empfindlichkeit der Empfangsanlage sind in Realität etwa 20 dB bis 40 dB.

Eine vorteilhafte Ausbildung wird dadurch geschaffen, daß die Umhüllung an der dem U-Boot zugewandten Seite eine Aufnahmeöffnung etwa entsprechend des Turmes aufweist.

Um die Spitzenwirkung elektromagnetischer Felder für die Abschirmung zu nutzen, ist vorgesehen, daß die dem U-Boot zugewandten Bereiche der Umhüllung nach außen weisende blenderartige Abwinklungen aufweisen.

Zur Erfüllung der Erfordernisse der Abschirmung wird vorgeschlagen, daß Material der Umhüllung durch Materialschichten aus unterschiedlichen Materialien gebildet ist.

Eine Ausführung der haubenartigen Umhüllung besteht darin, daß die Umhüllung containerartig ausgebildet ist und mindestens in den Eckbereichen Massebänder angeordnet sind, die die Umhüllung elektrisch leitfähig mit dem Umgebungswasser verbinden.

In der Zeichnung sind Ausführungsbeispiele der Erfindung mit einer containerartigen Umhüllung schematisch dargestellt. Es zeigen:

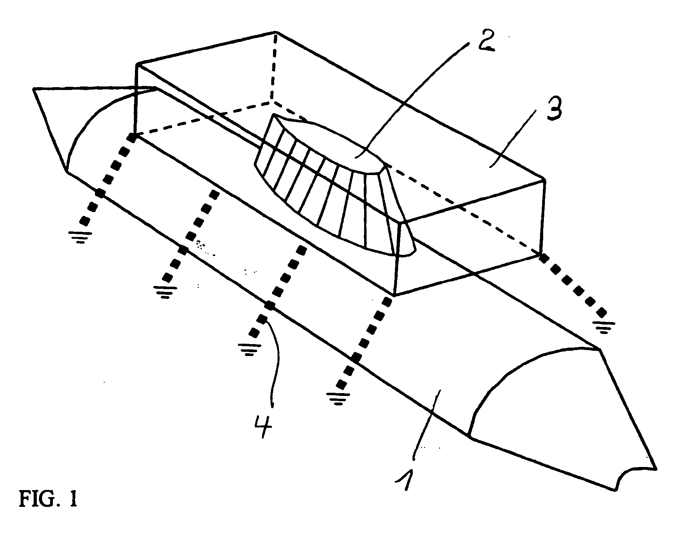

Fig. 1 eine Prinzipdarstellung einer auf einen Turm eines U-Bootes aufgesetzten Umhüllung;

Fig. 2 eine Umhüllung mit einer dem Turm angepaßten Aufnahmeöffnung auf der dem U-Boot zugewandten Seite und

Fig. 3 eine Umhüllung mit nach außen weisenden blendartigen Abwinklungen an einer unteren Öffnungsseite der Umhüllung

Es ist ein U-Bootskörper 1 mit einem Turm 2 angeordnet, der im Turm 2 nicht näher dargestellte Antennen der VLF-Systeme aufweist.

Der Turm 2 ist mit einer Umhüllung 3 versehen, die dem U-Bootskörper 1 zugeordnet ist. Die Umhüllung 3 ist mit Massebändern 4 versehen, die im Umgebungswasser eintauchen, um eine niederimpedante Verbindung herzustellen. Bei niedrigen Frequenzen stellen die Massebänder eine weitere geschlossene Fläche aufgrund der großen Wellenlänger dar.

Die zugeordnete geschlossene Umhüllung 3 mit einer Aufnahmeöffnung 5 zur Aufnahme des Turmes 2 ist aus elektrisch leitfähigem Material, wie beispielsweise Stahl, mit einer Leitfähigkeit und relativen Permeabilität bemessen, so daß sich eine Dämpfung im Bereich von etwa 20 dB bis 40 dB ergibt. Hierbei ist die Materialstärke und das Material bzw. es sind die verwendeten unterschiedlichen Materialschichten zu berücksichtigen.

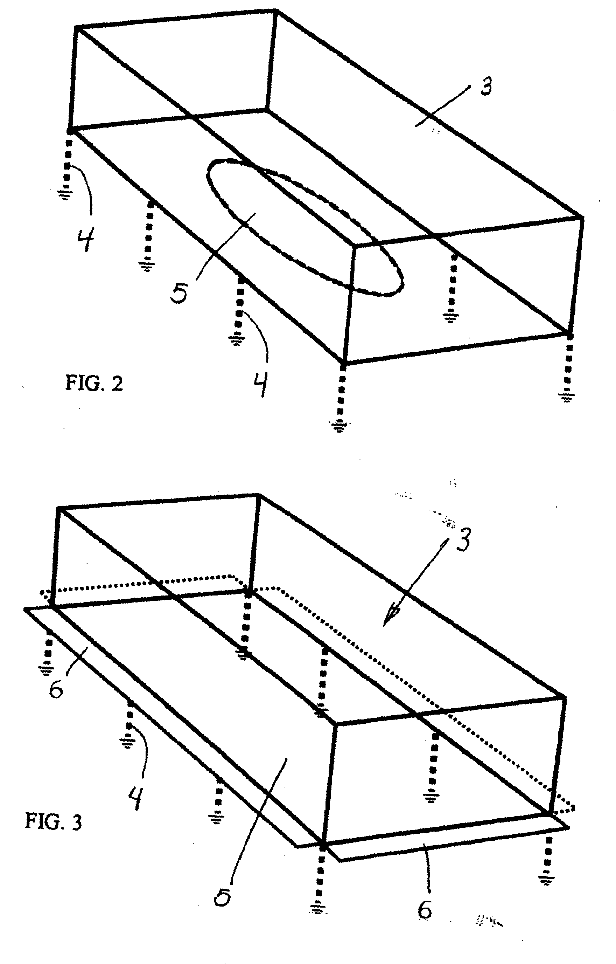

Gemäß Fig. 2 ist die Aufnahmeöffnung 5 der Umhüllung 3 den Abmessungen des Turmes 2 angepaßt.

In Fig. 3 ist in unteren, dem U-Bootskörper 1 zugewandten Bereichen der Umhüllung mit nach außen weisenden blenderartigen Abwinklungen 6 versehen, um eine Spitzenwirkung der Abschirmung zu erzeugen.

Die Wandstärke und die Materialeigenschaften werden so ausgelegt, daß die Absorptionsdämpfung mindestens 20 dB über der benötigten Schirmwirkung liegt.

Die Auswahl des Material relative Permeabilität mü_r (bezogen auf Luft) und Kappa_r (bezogen auf Kupfer) und der Wandstärke (t) hängen über folgende Gleichung von der Frequenz und der geforderten Dämpfung ab:

$$\frac{A}{dB} = 130{,}3 \, \frac{t}{mm} \sqrt{\frac{f}{MHz} \, \mu r \chi r}$$

A=Absorptionsdämpfung (dB)
t=Wandstärke (mm)
f=Frequenz (MHz)
$\gamma$r= relative Permeabilität bezogen auf Luft

$\chi$r=relative Leitfähigkeit bezogen auf Kupfer

## Patentansprüche

1. Vorrichtung zur Durchführung eines EMV-Systemtestes für Antennen von VLF-Systemen im Turm von U-Booten im Überwasserbetrieb durch Schirmung elektromagnetischer Felder, **dadurch gekennzeichnet, daß** auf den Turm des U-Bootes (1) eine haubenartige Umhüllung (3) mit einem dem U-Boot zugewandten Aufnahmebereich (5) für den Turm (2) aufsetzbar ist und die Umhüllung (3) mit Massebändern (4) zum Eintauchen ins Umgebungswasser versehen ist, wobei die haubenartige Umhüllung (3) aus einem elektrisch leitfähigen Material mit einer Leitfähigkeit und relativen Permeabilität zur Dämpfung im Bereich von etwa 20 dB bis 40 dB ausgelegt ist.

2. Vorrichtung nach Anspruch 1, **dadurch gekennzeichnet, daß** die Umhüllung (3) an der dem U-Boot (1) zugewandten Seite eine Aufnahmeöffnung etwa entsprechend des Turmes aufweist.

3. Vorrichtung nach Anspruch 1 oder 2, **dadurch gekennzeichnet, daß** die dem U-Boot (1) zugewandten Bereiche der Umhüllung (3) nach außen weisende blendenartige Abwinklungen (6) aufweisen.

4. Vorrichtung nach einem der Ansprüche 1 bis 3, **dadurch gekennzeichnet, daß** Material der Umhüllung (3) durch Materialschichten aus unterschiedlichen Materialien gebildet ist.

5. Vorrichtung nach einem der Ansprüche 1 bis 4, **dadurch gekennzeichnet, daß** die Umhüllung (3) containerartig ausgebildet ist und mindestens in den Eckbereichen Massebänder (4) angeordnet sind, die die Umhüllung (3) elektrisch leitfähig mit dem Umgebungswasser verbinden.

## Claims

1. Apparatus for implementing an EMC system test for antennas of VLF systems in the tower of submarines in surface operation by shielding of electromagnetic fields, **characterised in that** a hood-like cover (3) with a receiving region (5), facing towards the submarine, for the tower (2) is capable of being mounted onto the tower of the submarine (1) and the cover (3) is provided with earth straps (4) for immersing in the surrounding water, the hood-like cover (3) being designed from an electrically conductive material with a conductivity and relative permeability for attenuation within the range from approximately 20 dB to 40 dB.

**2.** Apparatus according to Claim 1, **characterised in that** on the side facing towards the submarine (1) the cover (3) exhibits a receiving opening approximately corresponding to the tower.

**3.** Apparatus according to Claim 1 or 2, **characterised in that** the regions of the cover (3) facing towards the submarine (1) exhibit outward-pointing panel-type angled portions (6).

**4.** Apparatus according to one of Claims 1 to 3, **characterised in that** material of the cover (3) is constituted by material layers consisting of differing materials.

**5.** Apparatus according to one of Claims 1 to 4, **characterised in that** the cover (3) is of container-like design and earth straps (4) which connect the cover (3) to the surrounding water in electrically conductive manner are arranged at least in the corner regions.

**Revendications**

**1.** Procédé pour l'exécution d'un test de système EMV pour antennes de systèmes VLF dans le kiosque de sous-marins lors de la marche en surface, par en formant écran vis-à-vis des champs électromagnétiques, **caractérisé en ce que**, sur le kiosque du sous-marin (1), peut être placée une enveloppe (3) en forme de capot, avec une zone de réception (5) pour le kiosque, laquelle est orientée vers le sous-marin, et que ladite enveloppe (3) est pourvue de bandes de mise à la masse (4), qui sont destinées à être plongées dans l'eau environnante, l'enveloppe (3) en forme de capot, en matière conductrice de l'électricité, présentant une conductivité et une perméabilité relative pour une atténuation dans une plage d'environ 20 à 40 dB.

**2.** Procédé selon la revendication 1, **caractérisé en ce que** l'enveloppe (3) présente, sur le côté orienté vers le sous-marin, une ouverture de réception, qui correspond à peu près au kiosque.

**3.** Procédé selon revendication 1 ou 2, **caractérisé en ce que** la zone de l'enveloppe (3), qui est orientée vers le sous-marin, présente des pièces (6) genre écrans, qui sont orientées vers l'extérieur.

**4.** Procédé selon l'une des revendications 1 à 3, **caractérisé en ce que** le matériau de l'enveloppe (3) est formé par des couches de matières différentes.

**5.** Procédé selon l'une des revendications 1 à 4, **caractérisé en ce que** l'enveloppe (3) est conçue en forme de conteneur et que des bandes de mise à la masse (4), qui relient en conductivité électrique l'enveloppe (3) à l'eau environnante, sont disposées au moins dans les zones d'angle.

FIG. 1

FIG. 2

FIG. 3

**EP 2 091 102 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1612887 A